Europäisches Patentamt

European Patent Office

Office européen des brevets

(11) Publication number: **0 074 212**
**B1**

(12) **EUROPEAN PATENT SPECIFICATION**

(45) Date of publication of patent specification: **12.11.86**

(51) Int. Cl.⁴: **C 23 C 14/22**

(21) Application number: **82304455.7**

(22) Date of filing: **24.08.82**

(54) Apparatus for forming thin film.

(30) Priority: **24.08.81 JP 132507/81**

(43) Date of publication of application:
**16.03.83 Bulletin 83/11**

(45) Publication of the grant of the patent:
**12.11.86 Bulletin 86/46**

(84) Designated Contracting States:
**DE FR GB**

(56) References cited:
**EP-A-0 064 288**
**WO-A-81/00862**
**GB-A-2 048 230**
**US-A-4 123 316**
**US-A-4 262 631**

**PATENTS ABSTRACTS OF JAPAN, vol. 2, no.
125, 20th October 1978, page 7448 E 78;
PATENTS ABSTRACTS, vol. 2, no. 41, 17th
March 1978, page 4723 C 77;**

(73) Proprietor: **Kabushiki Kaisha Toshiba
72, Horikawa-cho Saiwai-ku
Kawasaki-shi Kanagawa-ken 210 (JP)**

(72) Inventor: **Hatayama, Tamotsu
1-126, Shinmatsudo
Matsudo-shi Chiba-ken (JP)**
Inventor: **Ito, Hiroshi
2-16-15, Daita
Setagaya-ku Tokyo (JP)**

(74) Representative: **Freed, Arthur Woolf et al
MARKS & CLERK 57-60 Lincoln's Inn Fields
London WC2A 3LS (GB)**

Courier Press, Leamington Spa, England.

# Description

This invention relates to an apparatus for forming a thin film by decomposing the raw material gas under a low pressure.

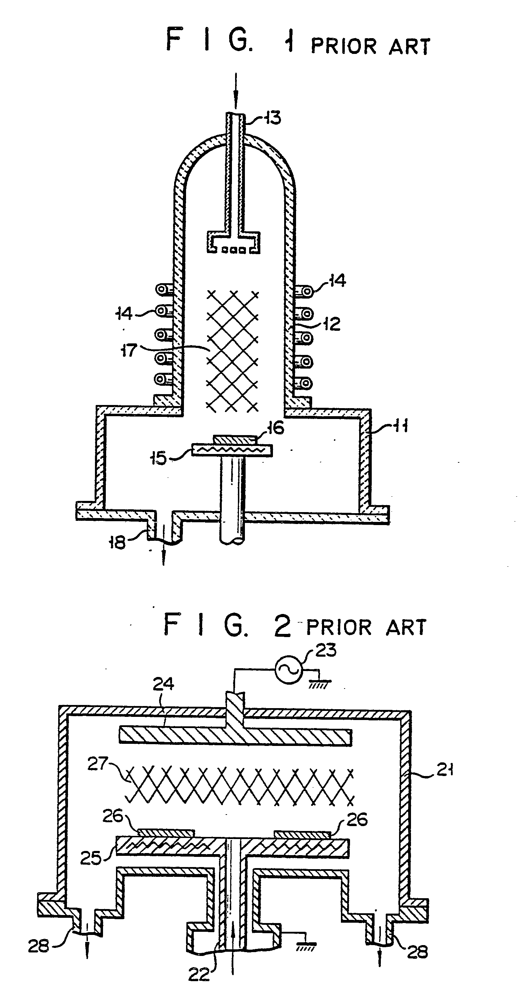

Figures 1 and 2 show conventional apparatuses for forming a thin film by decomposing the raw material gas under a low pressure by means of electric discharge, i.e. Figure 1 showing an inductive coupling type plasma CVD apparatus and Figure 2 showing a capacitive coupling type plasma CVD apparatus. In the apparatus shown in Figure 1, the raw material gas is introduced through a gas inlet pipe 13 into a quartz vessel 12 disposed on a metal chamber 11. The raw material gas introduced into the vessel 12 is decomposed by the glow discharge from a high frequency coil 14 so as to form a thin film on a substrate 16 disposed on a susceptor 15 provided with a heater. Reference numeral 17 denotes the plasma generated by the glow discharge decomposition of the gas. As apparent from the drawing, the waste gas is withdrawn through an outlet pipe 18. In the capacitive coupling type plasma CVD apparatus shown in Figure 2, the raw material gas is introduced through a gas inlet pipe 22 into a metal chamber 21 so as to be decomposed by the glow discharge occurring between an RF electrode 24 connected to a high frequency power source 23 and a counter electrode 25 connected to the ground and having a heater disposed therein. As a result of the gas decomposition, a thin film is formed on a substrate 26 disposed on the counter electrode 25. Reference numeral 27 denotes the plasma generated by the glow discharge decomposition of the raw material gas. As apparent from the drawing, the waste gas is withdrawn through an outlet pipe 28.

The conventional apparatuses outlined above permit forming a thin film of desired properties by properly selecting the operating conditions. It is also possible to form a thin film at a high speed by properly controlling the operating conditions such as the high frequency power applied to the electrodes, gas flow rate, gas pressure, etc. The film-forming speed can also be increased by, for example, applying a magnetic field or electric field to the substrate on which is formed a thin film. However, various operating conditions must be controlled properly for increasing the film-forming speed. In addition, the actual film-forming speed widely differs depending on the apparatus used, rendering it necessary to collect abundant data. Further, a highly skilled operator is required for increasing the film-forming speed satisfactorily. It should also be noted that, if the high frequency power applied to the electrode is increased for increasing the film-forming speed, it is impossible to obtain a thin film of high density. Further, materials of the vessel wall may be mixed in considerable quantities into the resultant film because of the sputtering phenomenon accompanying the electric discharge within the vessel, failing to obtain a thin film of satisfactory quality.

EP—A1 0 064 288 which falls within Articles 54(3) and (4) of the European Patent Convention discloses apparatus for forming a thin film on a substrate, having a source chamber which receives raw material gas, the raw material gas in the source chamber being decomposed by radio frequency energy. The source chamber communicates with a working chamber through a small aperture nozzle, the substrate and an anode being disposed in the working chamber which has a gas outlet.

An object of this invention is to provide an apparatus which permits forming a thin film of high quality at a high speed without involving complex adjustment of the operating conditions of the apparatus.

According to this invention, there is provided an apparatus for forming a thin film, comprising a vacuum vessel provided with a gas outlet port, introduction means for introducing raw material gas into the vacuum vessel, decomposing means for decomposing the raw material gas, and means for supporting within the vacuum vessel a substrate on which is formed a thin film of a decomposed gas component; characterized in that the vacuum vessel comprises a first chamber provided with said introduction means for introducing all of the raw material gas into the first chamber, a second chamber which is connected to said first chamber and is provided with said gas outlet port, and a perforated partition plate partitioning said vessel into said first and second chambers for maintaining the gas pressure within the second chamber lower than that within the first chamber; in that said decomposing means for decomposing the raw material gas comprises separate high frequency electric discharge generating means acting on the gas in said first and second chambers; and in that said means for supporting the substrate is disposed within the second chamber.

To be brief, the raw material gas is decomposed in two stages in the apparatus of the present invention. The particular construction of the apparatus permits easily increasing the film-forming speed. In addition, a thin film of high quality can be obtained with a high reproducibility in spite of the high film-forming speed.

The hole of the partition plate is desirably larger than the length of mean free path of the gas passing therethrough and should permit maintaining the pressure within the second chamber lower by at least 0.01 Torr (1.33 pascals), preferably at least 0.1 Torr (13.3 pascals) than the pressure within the first chamber. The partition plate may be provided with a single hole or a plurality of holes as far as the above-noted conditions are satisfied. Further, the first chamber in which is performed the raw material gas decomposition alone may be divided into a plurality of sub-sections using suitable partition means so as to control properly the raw material gas decomposition.

This invention can be more fully understood from the following detailed description when taken in conjunction with the accompanying drawings, in which:

Figure 1 is a cross sectional view schematically showing a conventional inductive coupling type plasma CVD apparatus;

Figure 2 is a cross sectional view schematically showing a conventional capacitive coupling type plasma CVD apparatus;

Figure 3 is a cross sectional view schematically showing an inductive coupling type plasma CVD apparatus according to one embodiment of the present invention; and

Figure 4 is a cross sectional view schematically showing a capacitive coupling type plasma CVD apparatus according to another embodiment of the present invention.

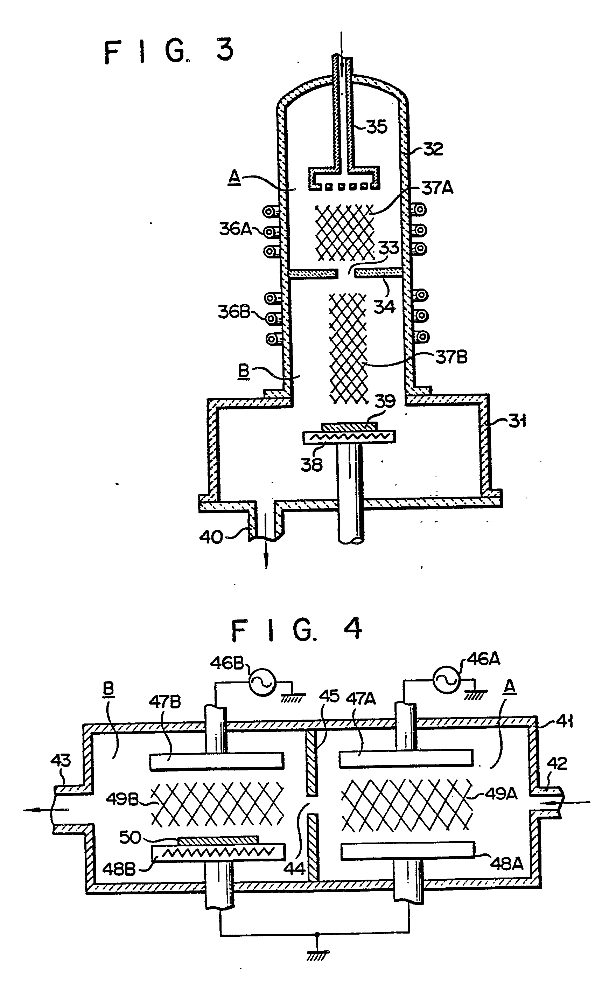

Figure 3 shows an inductive coupling type plasma CVD apparatus according to one embodiment of the present invention. As seen from the drawing, a quartz vessel 32 having an inner diameter of, for example, 15 cm is mounted to a metal chamber 31 so as to form a vacuum vessel. The vacuum vessel is divided into an upper first chamber A and a lower second chamber B by a partition means e.g. a quartz partition plate 34 provided with a small hole 33 having a diameter of, for example, 1 to 2 cm. During operation, the partition plate 34 permits maintaining the pressure within the second chamber B lower than that within the first chamber A. The raw material gas introduced into the first chamber A through a gas inlet pipe 35 is decomposed by the glow discharge from a high frequency coil 36A. Reference numeral 37A denotes the plasma produced by the discharge decomposition. The produced species by the plasma 37A and the undecomposed raw material gas are introduced into the second chamber B through the hole 33 of the partition plate 34. A glow discharge decomposition is further performed within the second chamber B utilizing the discharge from a high frequency coil 36B so as to generate a plasma 37B. As a result, a thin film is formed on a desired substrate 39 disposed on a susceptor 38 having a heater disposed therein. Reference numeral 40 denotes an outlet pipe connected to a vacuum pump. As a result of this construction, the raw material gas within the vessel 32 mainly flows from the first chamber A toward the second chamber B.

As apparent from the foregoing description, the raw material gas is decomposed in two stages, leading to an increased film-forming speed because of the improved decomposition efficiency. In addition, the film-forming speed is increased with the high frequency power held substantially equal to that for the prior art. It follows that the apparatus shown in Figure 3 permits increasing the film-forming speed without deteriorating the formed film.

A thin film was actually formed by using the apparatus shown in Figure 3. Specifically, an amorphous silicon film was formed by using a hydrogen-based raw material gas containing 10% of silane ($SiH_4$). (The hydrogen acted as a carrier.) The silane flow rate was 50 SCCM (cc/min at standard states); the high frequency power for each of the coils 36A and 36B was 5 W; the substrate temperature was 270°C; the pressure within the first chamber A was 1.0 Torr (133 pascals); and the pressure within the second chamber B was 0.1 Torr (13.3 pascals). The film-forming a speed was found to be 400 to 500 Å/min (4 to $5\times10^{-8}$ metres/min). In contrast, the film-forming speed was found to be 80 to 150 Å/min (8 to $15\times10^{-9}$ metres/min) in the case of the conventional apparatus shown in Figure 1 under the same operating conditions except that the high frequency power applied was 10 W.

Figure 4 shows a capacitive coupling type plasma CVD apparatus according to another embodiment of the present invention. It is seen that a metal chamber 41 is provided with a raw material gas inlet pipe 42 and a gas outlet pipe 43. Also, the metal chamber 41 is divided by a metal partition plate 45 provided with a hole 44 having a diameter of 1 to 2 cm into a first chamber A communicating with the gas inlet pipe 42 and a second chamber B communicating with the gas outlet pipe 43. During operation of the apparatus, the partition plate 45 permits maintaining the pressure within the second chamber B lower than that within the first chamber A. The raw material gas introduced into the first chamber A is subjected to a discharge decomposition in the region between an RF electrode 47A connected to a high frequency power source 46A and a counter electrode 48A having a diameter of about 15 cm connected to the ground so as to generate a plasma 49A. The produced species by the plasma 49A and the undecomposed gas are introduced into the second chamber B. Naturally, the undecomposed gas is further subjected to a discharge decomposition in the region between an RF electrode 47 connected to a high frequency power source 46B and a counter electrode 48B having a diameter of about 20 cm connected to the ground so as to generate a plasma 49B. A heater is disposed within the counter electrode 48B and a desired substrate 50 is disposed on the electrode 48B. Of course, a thin film is formed on the substrate 50 as a result of the raw material gas decomposition.

A thin film was actually formed by using the apparatus shown in Figure 4. Specifically, an amorphous silicon film was formed by using a hydrogen-based raw material gas containing 10% of silane. The silane flow rate was 100 SCCM; the high frequency power applied to each of the RF electrodes 47A and 47B was 5 W; the substrate temperature was 270°C; the pressure within the first chamber A was 1.0 Torr (133 pascals); and the pressure) within the second chamber B was 0.5 Torr (67 pascals). The film-forming speed was found to be 600 to 700 Å/min (6 to $7\times10^{-8}$ metres/min) in contrast, the film-forming speed was found to be 80 to 160 Å/min (8 to $16\times10^{-9}$ metres/min) in the case of the conventional apparatus shown in Figure 2 under the same operating conditions.

As for the raw material gas, it is also possible to employ pure silane gas in place of the above hydrogen-based silane gas. Further, it is possible to use as the raw material gas silane ($SiH_4$) mixed with at least one doping gas of $GeH_4$, $SnCl_4$, $CH_4$, $C_2H_4$, $C_2H_6$, $B_2H_6$, $PH_3$, $AsH_3$, $O_2$, $N_2$, $N_2O$ and $NH_3$ gases. The doping gas may be directly introduced into the second chamber B. In this case, the corresponding chamber B would have a gas inlet pipe (not shown) through which the doping gas is introduced into the chamber B.

Each of the embodiments described above is directed to the raw material gas decomposition by electric discharge utilizing a high frequency power. In another embodiment, a preliminary decomposition chamber may be provided before the first chamber A. In this case, only hydrogen gas is introduced to the preliminary decomposition chamber and subjected to the discharge of micro-waves, thereby converting the hydrogen gas into its radical. The hydrogen radical is then introduced into the first chamber A being introduced with the raw material gas or hydrogen-based raw material gas to increase the decomposition efficiency.

As described above in detail, the apparatus of the present invention permits increasing the film-forming speed quite easily without deteriorating the formed film. In addition, the apparatus permits forming a thin film of high quality with high reproducibility.

**Claims**

1. An apparatus for forming a thin film, comprising a vacuum vessel (32, 41) provided with a gas outlet port (40, 43), introduction means (35, 42) for introducing raw material gas into the vacuum vessel (32, 41), decomposing means for decomposing the raw material gas, and means (38, 48B) for supporting within the vacuum vessel a substrate (39, 50) on which is formed a thin film of a decomposed gas component; characterized in that the vacuum vessel comprises a first chamber (A) provided with said introduction means (35, 42) for introducing all of the raw material gas into the first chamber (A), a second chamber (B) which is connected to said first chamber (A) and is provided with said gas outlet port (40, 43), and a perforated partition plate (34, 45) partitioning said vessel into said first and second chambers for maintaining the gas pressure within the second chamber (B) lower than that within the first chamber (A); in that said decomposing means for decomposing the raw material gas comprises separate high frequency electric discharge generating means (36A, 36B, 47A, 47B, 48A, 48B) acting on the gas in said first and second chambers; and in that said means (38, 48B) for supporting the substrate (39, 50) is disposed within the second chamber (B).

2. Apparatus according to claim 1, characterized in that the decomposing means is of the inductive coupling type.

3. Apparatus according to claim 1, characterized in that the decomposing means is of the capacitive coupling type.

4. Apparatus according to claim 1, characterized in that the partition plate (34, 45) is provided with a single hole (33).

5. Apparatus according to claim 1, characterized in that the partition plate (34, 45) is provided with a plurality of holes.

6. Apparatus according to claim 1, characterized in that the first chamber (A) consists of a plurality of sub-sections each provided with high frequency electric discharge generating means for decomposing the raw material gas.

**Patentansprüche**

1. Vorrichtung zur Herstellung einer dünnen Schicht, umfassend ein Vakuumgefäß (32, 41) mit einem Gasauslaßstutzen (40, 43), eine Einführeinrichtung (35, 42) zum Einführen eines Rohmaterialgases in das Vakuumgefäß (32, 41), eine Zersetzungseinrichtung zum Zersetzen des Rohmaterialgases und eine Einrichtung (38, 48B), die innerhalb des Vakuumgefäßes ein Substrat (39, 50) trägt, auf dem eine dünne Schicht aus einer zersetzten Gaskomponente erzeugt wird, dadurch gekennzeichnet, daß das Vakuumgefäß eine erste Kammer (A), die mit der Einführeinrichtung (35, 42) zum Einführen des gesamten Rohmaterialgases in die erste Kammer (A) versehen ist, eine zweite Kammer (B), die mit der ersten Kammer (A) verbunden und mit dem Gasauslaßstutzen (40, 43) versehen ist, sowie eine das Gefäß in die erste und zweite Kammer unterteilende perforierte Trennplatte (34, 45), um den Gasdruck in der zweiten Kammer (B) kleiner zu halten als in der ersten Kammer (A), aufweist, daß die Zersetzungseinrichtung zum Zersetzen des Rohmaterialgases getrennte, eine elektrische Hochfrequenzentladung erzeugende Einrichtungen (36A, 36B, 47A, 47B, 48A, 48B), die auf das in erster und zweiter Kammer enthaltene Gas einwirken, aufweist und daß die das Substrat (39, 50) tragende Einrichtung (38, 48B) in der zweiten Kammer (B) angeordnet ist.

2. Vorrichtung nach Anspruch 1, dadurch gekennzeichnet, daß die Zersetzungseinrichtung vom induktiven Ankopplungstyp ist.

3. Vorrichtung nach Anspruch 1, dadurch gekennzeichnet, daß die Zersetzungseinrichtung vom kapazitiven Ankopplungstyp ist.

4. Vorrichtung nach Anspruch 1, dadurch gekennzeichnet, daß die Trennplatte (34, 35) mit einer einzigen Öffnung (33) versehen ist.

5. Vorrichtung nach Anspruch 1, dadurch gekennzeichnet, daß die Trennplatte (34, 45) mit einer Anzahl von Öffnungen versehen ist.

6. Vorrichtung nach Anspruch 1, dadurch gekennzeichnet, daß die erste Kammer (A) aus einer Anzahl von Unterabschnitten besteht, von denen jeder mit eine elektrische Hochfrequenzentladung erzeugenden Einrichtungen zum Zersetzen des Rohmaterialgases versehen ist.

## Revendications

1. Appareil pour obtenir un film mince, comportant un récipient sous vide (32, 41) présentant un orifice de sortie du gaz (40, 43), des moyens d'introduction (35, 42) pour introduire dans le récipient sous vide (32, 41) le gaz formant la matière première, des moyens de décomposition pour décomposer le gaz formant la matière première et des moyens (38, 48B) pour supporter dans le récipient sous vide un substrat (39, 50) sur lequel se forme un film mince d'un composant du gaz décomposé, caractérisé en ce que le récipient sous vide comporte une première chambre (A) qui présente lesdits moyens d'introduction (35, 42) pour introduire dans la première chambre (A) la totalité du gaz formant la matière première, une seconde chambre (B) reliée à ladite première chambre (A) et présentant ledit orifice de sortie du gaz (40, 43), ainsi qu'un panneau perforé de division (35, 45) qui divise ledit récipient en ladite première chambre et ladite seconde chambre pour maintenir la pression du gaz à l'intérieur de la seconde chambre (B) inférieure à la pression dans la première chambre (A); en ce que lesdits moyens de décomposition pour décomposer le gaz formant la matière première comportent des moyens distincts générant une décharge électrique à haute fréquence (36A, 36B, 47A, 47B, 48A, 48B) agissant sur le gaz dans ladite première chambre et ladite seconde chambre; et en ce que lesdits moyens (38, 48B) pour supporter le substrat (39, 50) sont disposés dans la seconde chambre (B).

2. Appareil selon la revendication 1, caractérisé en ce que les moyens de décomposition sont du type à couplage inductif.

3. Appareil selon la revendication 1, caractérisé en ce que les moyens de décomposition sont du type à couplage capacitif.

4. Appareil selon la revendication 1, caractérisé en ce que le panneau de division (34, 45) comporte un unique trou (33).

5. Appareil selon la revendication 1, caractérisé en ce que le panneau de division (34, 45) comporte une pluralité de trous.

6. Appareil selon la revendication 1, caractérisé en ce que la première chambre (A) est constituée d'une pluralité de sous-sections présentant chacune des moyens de génération d'une décharge électrique à haute fréquence pour décomposer le gaz formant la matière première.

# F I G. 1 PRIOR ART

# F I G. 2 PRIOR ART

# F I G. 3

# F I G. 4